# FASCICULE DE BREVET EUROPEEN

(11) **EP 0 829 185 B1**
(45) Date de publication et mention de la délivrance du brevet: **04.08.1999**
(21) Numéro de dépôt: 96916190.0
(22) Date de dépôt: 10.05.1996
(51) Int. Cl.: H05H 1/46

(54) **CAVITE DE DECHARGE FORTE PUISSANCE A ONDE LENTE DANS LE DOMAINE DES RADIOFREQUENCES**
HOCHLEISTUNG-VERZOEGERUNGENTLADUNGSKAVITAET IM HOCHFREQUENZBEREICH
SLOW-WAVE HIGH-POWER DISCHARGE CAVITY OPERATING IN THE RADIOFREQUENCY RANGE

(30) Priorité: 29.05.1995 FR 9506301
(43) Date de publication de la demande: 18.03.1998
(73) Titulaire: USTL - UNIVERSITE DES SCIENCES ET TECHNIQUES DE LILLE, 59650 Villeneuve d'Ascq (FR)
(72) Inventeur: GOUDMAND, Pierre, F-59800 Lille (FR); DESSEAUX, Odile, F-59800 Lille (FR); DUPRET, Christian, F-59110 La Madeleine (FR); MUTEL, Brigitte, F-59115 Leers (FR)
(74) Mandataire: Keib, Gérard
(86) Numéro de dépôt international: FR9600714
(87) Numéro de publication internationale: WO9639011

(56) Documents cités:
- EP-A- 0 376 546
- WO-A-94/21096
- US-A- 3 415 968
- US-A- 5 234 529
- US-A- 5 288 971
- US-A- 5 304 282

## Description

La présente invention concerne une cavité forte puissance à onde lente dans le domaine des radiofréquences pour créer des décharges plasma dans les gaz. Elle comprend un tube en matière diélectrique renfermant un gaz sous faible pression, ce tube étant entouré coaxialement par une structure à onde lente et une enceinte cylindrique en matière électriquement conductrice.

On connaît selon le brevet européen EP-A-0 376 546, une cavité à onde électromagnétique pour créer des décharges plasma dans un gaz, comprenant un tube en matière diélectrique renfermant un gaz sous faible pression. Ce tube est entouré coaxialement par une enceinte cylindrique en matière électriquement conductrice. Ce tube est lui-même entouré dans sa partie située dans l'enceinte cylindrique par un élément en matière électriquement conductrice enroulé hélicoidalement autour dudit tube. Cet élément est relié électriquement à un générateur d'onde.

La densité de puissance utilisée dans cette cavité se situe dans la plage de 0,05 W/cm³ à 1 W/cm³.

Selon le brevet US-A-5,234,529 on connait une cavité à onde électromagnétique tel que décrit dans le préambule de la première revendication.

Le problème de l'utilisation des radiofréquences pour la réalisation de coupleurs de type cavité réside en la longueur d'onde des fréquences considérées, qui implique des dimensions de coupleurs importantes. Une possibilité pour contourner cet inconvénient est l'utilisation de structures à onde lente. Dans ces structures, la longueur d'onde longitudinale dans le vide λo est multipliée par le rapport V_{P/C} où V_{P} est la vitesse de phase de l'onde dans la structure et C la célérité de la lumière. Dans le cas de l'hélice qui est décrite dans le brevet européen 0 376 546, on montre que l'on a en première approximation tgΨ≃ V_{P/C} où Ψ est l'angle que font les spires de l'hélice avec un plan perpendiculaire à l'axe de cette hélice. Un angle Ψ faible permet d'obtenir une vitesse de phase faible et donc une diminution notable de la longueur d'onde: λ = V_{P/C}. λo Dès lors pour une onde de fréquence égale à 13,56 MHz ayant une longueur d'onde dans le vide de 22,1 m environ on peut réaliser en jouant sur les paramètres dimensionnels de l'hélice un coupleur mesurant, par exemple pour un tube plasma de 6 cm de diamètre extérieur, 50 cm de longueur et 10 cm de diamètre, ou encore, toujours pour la même fréquence, un coupleur avec un tube plasma de 25 cm de diamètre extérieur, 80 cm de longueur et 40 cm de diamètre.

Ainsi, l'utilisation de radiofréquences, sur l'ensemble des bandes légales (40,68 MHz, 27 MHz, 13,56 MHz et 6,8 MHz) et l'utilisation d'une hélice permet théoriquement de réaliser des coupleurs sur un vaste domaine de dimensions. La présence sur le marché de générateur radiofréquence de forte puissance (>10 KW) offre la possibilité de générer de gros volumes de plasma avec une grande variété de gaz.

Le but de la présente invention est par conséquent de créer une cavité forte puissance à onde lente dans le domaine des radiofréquences, pour pouvoir créer des volumes de plasma importants.

L'invention vise ainsi une cavité à onde lente dans le domaine des radiofréquences à forte puissance pour créer des décharges plasma dans un gaz, comprenant un tube en matière diélectrique renfermant un gaz sous faible pression, ce tube étant entouré coaxialement par une enceinte cylindrique en matière électriquement conductrice, ledit tube étant lui-même entouré dans sa partie située dans l'enceinte cylindrique par un élément en matière électriquement conductrice enroulé hélicoïdalement autour dudit tube, cet élément étant relié électriquement à un générateur d'onde dans le domaine des radiofréquences, et cet élément étant en matière électriquement conductrice enroulé hélicoïdalement autour du tube à gaz étant un tube hélicoïdal, des moyens étant prévus pour faire circuler dans ce tube hélicoïdal un gaz pour assurer son refroidissement. Suivant l'invention ce tube hélicoïdal est maintenu à l'intérieur de l'enceinte cylindrique par une série d'entretoises en matière diélectrique reliant ledit tube hélicoïdal à la paroi de l'enceinte cylindrique.

La circulation de gaz par exemple d'air dans le tube hélicoïdal permet d'éviter tout risque d'échauffement lorsque ce tube est connecté à un générateur radiofréquence de puissance élevée.

De même, les entretoises diélectriques maintiennent parfaitement le tube hélicoïdal, ce qui rend également la cavité selon l'invention apte à supporter des puissances élevées, sans risque de déformation du tube hélicoïdal.

Selon une version préférée de l'invention, l'enceinte cylindrique est fermée à ses extrémités opposées par des flasques comportant chacune une ouverture circulaire de passage du tube à gaz, le diamètre de cette ouverture étant légèrement supérieur au diamètre dudit tube à gaz.

Cette disposition permet une certaine liberté de mouvement du tube à gaz par rapport aux flasques.

Selon une version avantageuse, la paroi de l'enceinte cylindrique comporte au moins une entrée de gaz de refroidissement.

Cette disposition permet également de refroidir la cavité soumise à des décharges de forte puissance. Le gaz de refroidissement s'échappe à l'extérieur par les ouvertures prévues dans les flasques.

Selon une autre particularité de l'invention, l'une des extrémités du tube hélicoïdal traverse la paroi de l'enceinte cylindrique et comporte des moyens pour la connecter électriquement à une prise coaxiale reliée au générateur radiofréquence, ladite extrémité du tube hélicoïdal étant raccordée à une source d'alimentation en gaz de refroidissement et l'autre extrémité du tube hélicoïdal débouchant à l'intérieur de l'enceinte cylindrique.

D'autres particularités et avantages de l'invention apparaîtront encore dans la description ci-après.

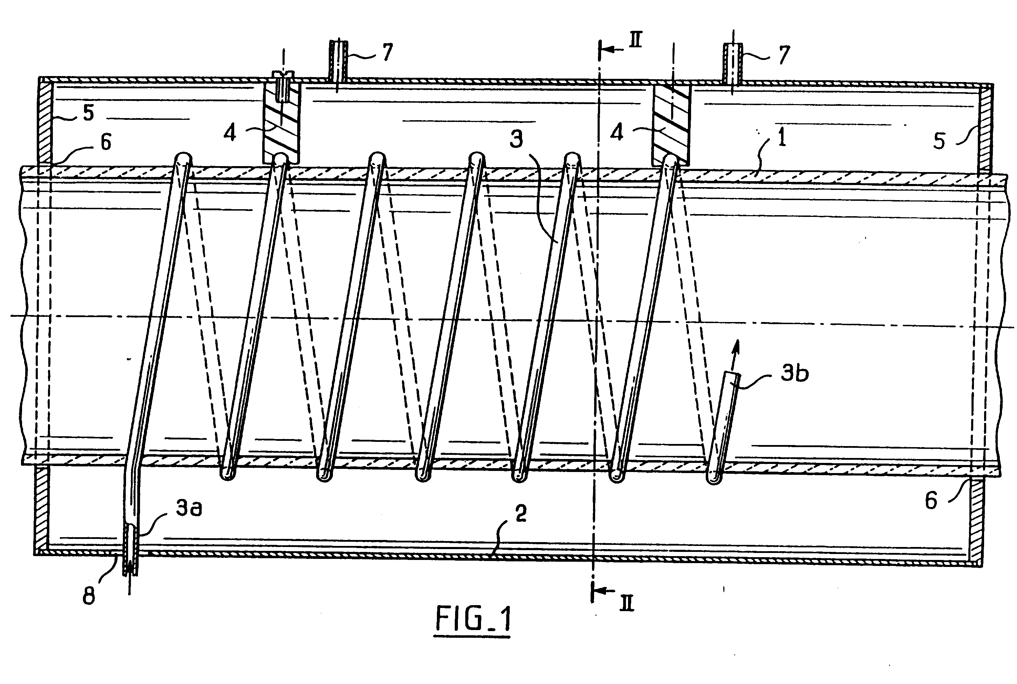

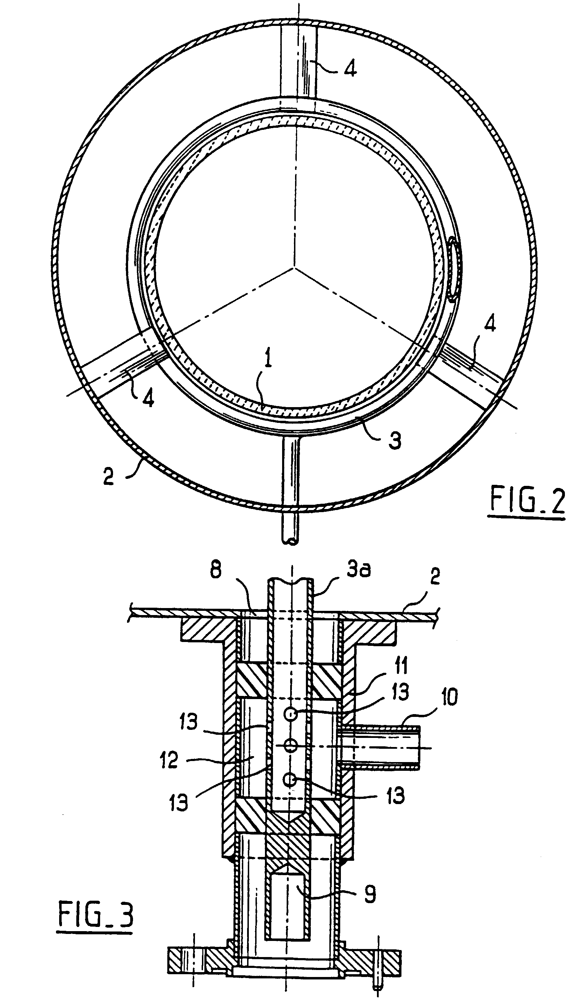

Aux dessins annexés, donnés à titre d'exemples non limitatifs:
- la figure 1 est une vue en coupe longitudinale d'une cavité à onde lente conforme à l'invention;
- la figure 2 est une vue en coupe suivant le plan II-II de la figure 1;
- la figure 3 est une vue en coupe longitudinale du dispositif d'alimentation en gaz du tube hélicoïdal de la cavité suivant l'invention;
- la figure 4 est un schéma de l'adaptateur d'impédance.
Dans la réalisation représentée sur les figures 1 et 2, la cavité forte puissance à onde lente dans le domaine des radiofréquences pour créer des décharges plasma dans un gaz, comprend un tube 1 en matière diélectrique telle que du quartz, renfermant un gaz sous faible pression. Ce tube 1 est entouré coaxialement par une enceinte cylindrique 2 en matière électriquement conductrice telle que de l'aluminium. Le tube 1 est lui-même entouré dans sa partie située dans l'enceinte cylindrique 2 par un élément 3 en matière électriquement conductrice telle que du cuivre, enroulé hélicoidalement autour du tube 1. Cet élément 3 est relié électriquement à un générateur d'onde dans le domaine des radiofréquences.

Conformément à l'invention, l'élément 3 en matière électriquement conductrice enroulé hélicoïdalement autour du tube à gaz 1 est un tube hélicoïdal.

Par ailleurs, des moyens sont prévus pour faire circuler dans le tube hélicoïdal 3 un gaz tel que de l'air, pour assurer son refroidissement.

Comme également montré par les figures 1 et 2, le tube hélicoïdal 3 est maintenu à l'intérieur de l'enceinte cylindrique 2 par des entretoises 4 en matière diélectrique telle que du polytétrafluoréthylène reliant le tube hélicoïdal 3 à la paroi de l'enceinte cylindrique 2. La figure 2 montre que les entretoises sont régulièrement réparties tout autour du tube 1.

On voit également sur la figure 1 que l'enceinte cylindrique 2 est fermée à ses extrémités opposées par des flasques 5 comportant chacun une ouverture circulaire 6 de passage du tube à gaz 1. Le diamètre de cette ouverture 6 est légèrement supérieur au diamètre du tube à gaz 1.

Par ailleurs, la paroi de l'enceinte cylindrique 2 comporte plusieurs tubulures 7 d'entrée de gaz de refroidissement, tel que de l'air.

La figure 3 montre en détail, que l'une 3a des extrémités du tube hélicoïdal 3 traverse une ouverture 8 de la paroi de l'enceinte cylindrique 2 et comporte un embout 9 destiné à être connecté électriquement à une prise coaxiale reliée au générateur radiofréquence. Par ailleurs l'extrémité 3a du tube hélicoïdal 3 est raccordée par une tubulure 10 à une source d'alimentation en gaz de refroidissement, tel que de l'air. D'autre part, l'autre extrémité 3b du tube hélicoïdal 3 débouche à l'intérieur de l'enceinte cylindrique 2.

Comme on le voit également sur la figure 3, l'extrémité 3a du tube hélicoïdal 3 raccordée à la source de gaz est entourée, dans une partie comprise entre l'ouverture 8 de la paroi de l'enceinte cylindrique 2 et l'embout 9 de raccordement à une prise coaxiale, par un manchon 11 définissant autour de l'extrémité 3a du tube, une cavité 12 fermée dans laquelle débouche la tubulure 10 d'admission de gaz de refroidissement.

D'autre part, la partie du tube hélicoïdal 3 située dans la cavité 12 comporte une série de trous 13 de passage pour le gaz de refroidissement.

Les générateurs radiofréquences de forte puissance disponibles dans le commerce ont une impédance standard de 50 ohms. L'impédance d'entrée de la cavité de décharge que l'on vient de décrire varie suivant de nombreux paramètres.

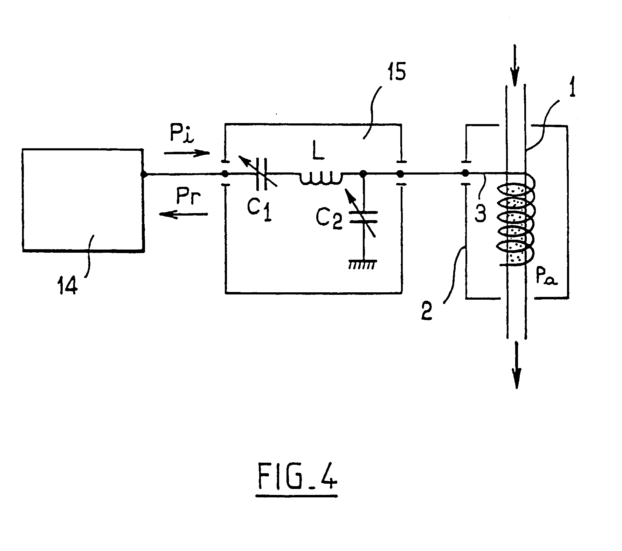

De ce fait, comme montré à la figure 4, le générateur radiofréquence 14 est relié au tube hélicoïdal par l'intermédiaire d'un circuit 15 d'adaptation de l'impédance. Ce circuit d'adaptation 15 comprend une capacité variable C₁ branchée en série avec une self L et une autre capacité variable C₂ branchée en dérivation avec cette self L.

Les capacités d'accords C₁ et C₂ permettent d'adapter l'impédance du coupleur, dont la valeur varie en fonction du gaz, de la pression et du débit de ce dernier, à l'impédance de sortie du générateur (50 Ω). Lorsque l'adaptation est réalisée, la puissance réfléchie Pᵣ est nulle et la puissance absorbée Pa par le coupleur est égale à la puissance incidente Pi.

Le circuit d'adaptation est donc purement réactif.

Les dimensions de la cavité que l'on vient de décrire peuvent par exemple être les suivantes:

| | |
|---|---|
| Longueur totale | 800 mm |
| Diamètre extérieur | 400 mm |
| Diamètre du tube à gaz 1 | 250 mm |
| Diamètre du tube hélicoïdal | 10 mm |

Les gaz pouvant être utilisés pour réaliser des décharges à l'intérieur du tube 1 peuvent être de l'argon, de l'azote, de l'oxygène, de l'oxyde d'azote, du trifluorure d'azote où tout autre gaz et mélanges utilisés dand l'industrie.

## Revendications

1. Cavité forte puissance à onde lente dans le domaine des radiofréquences pour créer des décharges plasma dans un gaz, comprenant un tube (1) en matière diélectrique renfermant un gaz sous faible pression, ce tube (1) étant entouré coaxialement par une enceinte cylindrique (2) en matière électriquement conductrice, ledit tube (1) étant lui-même entouré dans sa partie située dans l'enceinte cylindrique (2) par un élément (3) en matière électriquement conductrice enroulé hélicoïdalement autour dudit tube (1), cet élément (3) étant relié électriquement à un générateur d'onde dans le domaine des radiofréquences, cet élément (3) en matière électriquement conductrice enroulé hélicoïdalement autour du tube à gaz étant un tube hélicoïdal, des moyens étant prévus pour faire circuler dans ce tube hélicoïdal (3) un gaz pour assurer son refroidissement, caractérisé en ce que ce tube hélicoïdal (3) est maintenu à l'intérieur de l'enceinte cylindrique par des entretoises (4) en matière diélectrique reliant ledit tube hélicoïdal à la paroi de l'enceinte cylindrique (2).

2. Cavité conforme à la revendication 1, caractérisée en ce que l'enceinte cylindrique (2) est fermée à ses extrémités opposées par des flasques (5) comportant chacun une ouverture (6) circulaire de passage du tube à gaz (1), le diamètre de cette ouverture (6) étant légèrement supérieur au diamètre dudit tube à gaz (1).

3. Cavité conforme à la revendication 2, caractérisée en ce que la paroi de l'enceinte cylindrique (2) comporte au moins une entrée (7) de gaz de refroidissement.

4. Cavité conforme à l'une des revendications 1 à 3, caractérisée en ce que l'une (3a) des extrémités du tube hélicoïdal (3) traverse la paroi de l'enceinte cylindrique (2) et comporte des moyens pour la connecter électriquement à une prise coaxiale reliée au générateur radiofréquence, ladite extrémité (3a) du tube hélicoïdal (3) étant raccordée à une source d'alimentation en gaz de refroidissement et l'autre extrémité (3b) du tube hélicoïdal (3) débouchant à l'intérieur de l'enceinte cylindrique (2) .

5. Cavité conforme à la revendication 4, caractérisée en ce que ladite extrémité (3a) du tube hélicoïdal (3) raccordée à une source de gaz est entourée, dans une partie comprise entre la paroi de l'enceinte cylindrique (2) et lesdits moyens de raccordement à une prise coaxiale, par un manchon (11) définissant autour dudit tube une cavité (12) fermée dans laquelle débouche une tubulure (10) d'admission de gaz de refroidissement, la partie du tube hélicoïdal (3) située dans la cavité (12) comportant une série de trous de passage (13) pour le gaz de refroidissement.

6. Cavité conforme à l'une des revendications 1 à 5, caractérisée en ce que le générateur radiofréquence (14) est relié au tube hélicoïdal (3) par l'intermédiaire d'un circuit (15) d'adaptation de l'impédance.

7. Cavité conforme à la revendication 6, caractérisée en ce que le circuit d'adaptation (15) comprend une capacité variable (C₁) branchée en série avec une self (L) et une autre capacité variable (C₂) branchée en dérivation avec cette self (L).

## Patentansprüche

1. Hochleistungs-Verzögerungsentladungshohlraum in dem Bereich der Radiofrequenzen zur Erzeugung von Plasmaentladungen in einem Gas, mit einem Rohr (1) aus nichtleitendem Material, welches ein Gas unter niedrigem Druck einschließt, wobei dieses Rohr (1) koaxial von einer zylindrischen Einfassung (2) aus elektrisch leitendem Material umgeben ist, wobei das Rohr (1) selbst in seinem in der zylindrischen Einfassung (2) angeordneten Bereich von einem Element (3) aus elektrisch leitendem Material umgeben ist, welches spiralförmig um das Rohr (1) gewickelt ist, wobei dieses Element (3) elektrisch mit einem Wellengenerator für den Bereich der Radiofrequenzen verbunden ist, wobei dieses Element (3) aus elektrisch leitendem Material, welches spiralförmig um das Gasrohr gewickelt ist, ein spiralförmiges Rohr ist, wobei Vorrichtungen dafür eingerichtet sind, in diesem spiralförmigen Rohr (3) ein Gas zirkulieren zu lassen, um seine Kühlung sicherzustellen, dadurch gekennzeichnet, daß dieses spiralförmige Rohr (3) im Inneren der zylindrischen Einfassung von Verbindungsstegen (4) aus dielektrischem Material gehalten wird, welche das spiralförmige Rohr mit der Wand der zylindrischen Einfassung (2) verbinden.

2. Hohlraum gemäß Anspruch 1, dadurch gekennzeichnet, daß die zylindrische Einfassung (2) an ihren entgegengesetzten Enden von Flanschen (5) verschlossen ist, welche jeweils eine kreisförmige Öffnung (6) für den Durchgang des Gasrohrs (1) aufweisen, wobei der Durchmesser dieser Öffnung (6) etwas größer als der Durchmesser des Gasrohrs (1) ist.

3. Hohlraum gemäß Anspruch 2, dadurch gekennzeichnet, daß die Wand der zylindrischen Einfassung (2) wenigstens einen Einlaß (7) für das Kühlgas aufweist.

4. Hohlraum gemäß einem der Ansprüche 1 bis 3, dadurch gekennzeichnet, daß eines (3a) der Enden des spiralförmigen Rohrs (3) die Wand der zylindrischen Einfassung (2) durchquert und Vorrichtungen aufweist, um es elektrisch an eine koaxiale Abgriffstelle anzuschließen, welche mit dem Radiofrequenzgenerator verbunden ist, wobei das Ende (3a) des spiralförmigen Rohrs (3) an eine Kühlgasversorgungsquelle angeschlossen ist und das andere Ende (3b) des spiralförmigen Rohrs (3) in das Innere der zylindrischen Einfassung (2) einmündet.

5. Hohlraum gemäß Anspruch 4, dadurch gekennzeichnet, daß das Ende (3a) des spiralförmigen Rohrs (3), welches an eine Gasquelle angeschlossen ist, in einem Bereich zwischen der Wand der zylindrischen Einfassung (2) und den Vorrichtungen für den Anschluß an eine koaxiale Abgriffstelle von einer Muffe (11) umgeben ist, welche um dieses Rohr herum einen geschlossenen Hohlraum (12) definiert, in welchen ein Kühlgaseinlaßstutzen (10) mündet, wobei der in dem Hohlraum (12) angeordnete Bereich des spiralförmigen Rohrs (3) eine Reihe von Durchgangslöchern (13) für das Kühlgas aufweist.

6. Hohlraum gemäß einem der Ansprüche 1 bis 5, dadurch gekennzeichnet, daß der Radiofrequenzgenerator (14) mit dem spiralförmigen Rohr (3) mittels einer Impedanzanpassungsschaltung (15) verbunden ist.

7. Hohlraum gemäß Anspruch 6, dadurch gekennzeichnet, daß die Anpassungsschaltung (15) eine variable Kapazität (C₁), welche in Reihe an einen Drosselwiderstand (L) angeschlossen ist, und eine andere variable Kapazität (C₂) aufweist, welche parallel zu diesem Drosselwiderstand (L) angeschlossen ist.

## Claims

1. Radiofrequency-range slow-wave high-power cavity for creating plasma discharges in a gas, comprising a tube (1) made of dielectric material containing a gas under low pressure, this tube (1) being surrounded coaxially by a cylindrical enclosure (2) made of electrically conductive material, the said tube (1) being itself surrounded in its part lying in the cylindrical enclosure (2) by an element (3) made of electrically conductive material wound helically around the said tube (1), this element (3) being electrically connected to a radiofrequency-range wave generator, this element (3) made of electrically conductive material wound helically around the gas tube being a helicoid tube, means being provided for circulating a gas in this helicoid tube (3) in order to cool it, characterized in that this helicoid tube (3) is held inside the cylindrical enclosure by spacers (4) made of dielectric material connecting the said helicoid tube to the wall of the cylindrical enclosure (2).

2. Cavity according to Claim 1, characterized in that the cylindrical enclosure (2) is closed at its opposite ends by flanges (5), each comprising a circular opening (6) for the gas tube (1) to pass through, the diameter of this opening (6) being slightly larger than the diameter of the said gas tube (1).

3. Cavity according to Claim 2, characterized in that the wall of the cylindrical enclosure (2) comprises at least one inlet (7) for coolant gas.

4. Cavity according to any one of Claims 1 to 3, characterized in that one (3a) of the ends of the helicoid tube (3) passes through the wall of the cylindrical enclosure (2) and comprises means for electrically connecting it to a coaxial plug ccnnected to the radiofrequency generator, the said end (3a) of the helicoid tube (3) being connected to a source for supplying with coolant gas, and the other end (3b) of the helicoid tube (3) opening into the cylindrical enclosure (2).

5. Cavity according to Claim 4, characterized in that the said end (3a) of the helicoid tube (3), which end is connected to a gas source, is surrounded in a part contained between the wall of the cylindrical enclosure (2) and the said means for connection to a coaxial plug, by a sleeve (11) which, around the said tube, defines a closed cavity (12) into which a pipe (10) for admitting coolant gas opens, the part of the helicoid tube (3) located in the cavity (12) comprising a series of holes (13) for the coolant gas to pass through.

6. Cavity according to any one of Claims 1 to 5, characterized in that the radiofrequency generator (14) is connected to the helicoid tube (3) by means of an impedance-matching circuit (15).

7. Cavity according to Claim 6, characterized in that the matching circuit (15) comprises one variable capacitor (C₁) connected in series with an inductor (L) and another variable capacitor (C₂) connected in parallel with this inductor (L).
